# EUROPÄISCHE PATENTSCHRIFT

(11) **EP 1 931 944 B1**
(45) Veröffentlichungstag und Bekanntmachung des Hinweises auf die Patenterteilung: **27.04.2011**
(21) Anmeldenummer: 06792382.1
(22) Anmeldetag: 29.09.2006
(51) Int. Cl.: G01C 11/00, G09B 29/10, H05K 7/20

(54) **MULTIMEDIATERMINAL MIT EINEM MITTEL ZUR STATIONÄREN AUFSTELLUNG IM AUSSENRAUM**
MULTIMEDIA TERMINAL COMPRISING A MEANS FOR INSTALLING OUTSIDE IN A STATIONARY MANNER
TERMINAL MULTIMEDIA COMPRENANT UN SYSTEME QUI LUI PERMET D'ETRE DISPOSE EN UN EMPLACEMENT FIXE A L'EXTERIEUR

(30) Priorität: 07.10.2005 DE 102005049211
(43) Veröffentlichungstag der Anmeldung: 18.06.2008
(73) Patentinhaber: Art & Com AG, 10787 Berlin (DE)
(72) Erfinder: MAYER, Pavel, 10435 Berlin (DE)
(74) Vertreter: Gross, Felix
(86) Internationale Anmeldenummer: PCT/EP2006/009635
(87) Internationale Veröffentlichungsnummer: WO 2007/042197

(56) Entgegenhaltungen:
- EP-A1- 0 878 990
- WO-A-98/10629
- DE-A1- 10 028 713
- DE-U1- 8 510 233
- US-A1- 2004 007 347
- US-B1- 6 250 083

## Beschreibung

Die Erfindung betrifft ein Multimediaterminal mit einem Mittel zur stationären Aufstellung im Außenraum nach dem Oberbegriff des Anspruchs 1.

Die stationäre Aufstellung von Multimediaterminals im Außenraum ist grundsätzlich bekannt. Unter einem Multimediaterminal wird hier eine Datenverarbeitungsvorrichtung verstanden, bei der Video- und / oder Audiodaten für einen Benutzer angeboten werden, wobei ein Rechenmittel innerhalb des Multimediaterminals das Angebot-steuert. Über solche Multimediaterminals werden z.B. Informationen über den öffentlichen Nahverkehr angeboten.

Anders, als bei Datenverarbeitungsvorrichtungen, die nur gelegentlich im Außenraum aufgestellt werden, ergeben sich bei stationärer Aufstellung solcher Multimediaterminals besondere Probleme.

Ein Beispiel ist z.B. ein Multimediaterminal gemäß der DE 100 28 713.1 A1. In dieser Druckschrift wird eine Visualisierungsvorrichtung beschrieben, die stationär im Außenraum aufgestellt wird. Zum Schutz vor Umgebungseinflüssen, insbesondere Temperatureinflüssen, ist das besonders empfindliche Rechenmittel im Erdboden angeordnet, was aus Wartungsgründen nachteilig sein kann. Alternativ besteht die Möglichkeit, aufwändige Klimatisierungen oder Sonnenblenden zu verwenden.

Der vorliegenden Erfindung liegt die Aufgabe zugrunde, ein robustes Multimediaterminal zur stationären Aufstellung im Außenraum zu schaffen.

Diese Aufgabe wird erfindungsgemäß durch ein Multimediaterminal mit den Merkmalen des Anspruchs 1 gelöst. Das Multimediaterminal weist ein Rechenmittel und / oder mindestens ein Anzeigemittel in einem ersten Gehäuse auf, wobei das erste Gehäuse zur Abschirmung gegenüber Umgebungseinflüssen mindestens teilweise von einem zweiten Gehäuse umgeben ist. In mindestens einem Zwischenraum zwischen dem ersten Gehäuse und dem zweiten Gehäuse ist ein konvektiver Gasstrom, insbesondere ein Luftstrom, erzeugbar. Dieses doppelwandige Gehäuse sorgt dafür, dass empfindliche Teile gegen Vandalismus und auch UV-Strahlung geschützt sind. Durch den Zwischenraum wird eine Abschirmung des ersten Gehäuses mit darin enthaltenden wärmeempfindlichen Bauteilen geschaffen. Die Konvektion in mindestens einem Zwischenraum verstärkt diesen Effekt, so dass eine sehr robuste Vorrichtung geschaffen wird, die über sehr lange Zeit stationär im Außenraum aufstellbar ist.

Damit das mindestens eine Anzeigemittel des Multimediaterminals gut betrachtbar ist, ist das Anzeigemittel durch ein binokulares System durch einen Benutzer des Multimediaterminals betrachtbar. Binokulares Sehen ist für den Benutzer besonders entspannt möglich. Dabei ist es besonders vorteilhaft, wenn der Raum zwischen dem binokularen System und dem Anzeigemittel zur Vermeidung von Reflexen schwarz ausgebildet ist. Damit können preiswerte LCD-Displays verwendet werden.

Eine besonders robuste Bauform ergibt sich, weil das binokulare System eine einstückige Optik aufweist, deren dem Benutzer zugewandte Seite flach ausgebildet ist. An der dem Benutzer abgewandten Seite sind im Bereich der Augen jeweils konvexe Bereiche angeformt. Die konvexen Bereich dienen hier der gewünschten Vergrößerung. Durch diese Bauweise wird der binokulare Seheffekt noch verbessert. Die flache Seite, die dem Benutzer (und damit dem Außenraum) zugewandt ist, erlauben eine problemlose Reinigung. Auch bietet die flache Außenseite dieser Optike eine ästhetisch ansprechende Lösung.

Vorteilhaft ist es, wenn der Gasstrom durch Umgebungsluft gebildet wird, die durch mindestens ein erstes Ventilatormittel angesaugt wird. Dadurch wird eine erzwungene Konvektion verursacht, die einen Wärmestau effizient verhindert.

Zusätzlich oder auch alternativ ist es vorteilhaft, in einer Ausführungsform ein Mittel zur Erzeugung einer natürlichen Konvektion in mindestens einem Zwischenraum vorzusehen. Dies kann z.B. ein Kanal mit einem relativ geringen Durchmesser sein, in dem die Luft schnell abströmen kann, wobei die Strömung durch Temperaturunterschiede hervorgerufen oder unterstützt wird.

Ferner ist es von Vorteil, wenn das erste Gehäuse in einer Ausführungsform wasser-, staub- und / oder luftdicht ausgebildet ist.

Zur Verbesserung des Wärmeabtransportes in einer Ausführungsform des erfindungsgemäßen Multimediaterminals ist es vorteilhaft, wenn die Wandung des ersten Gehäuses mindestens teilweise aus einem Material hoher wärmeleitfähigkeit, insbesondere einem Metall besteht. Besonders geeignete Metalle sind z.B. Aluminium, Messing oder Kupfer. Dabei ist es besonders vorteilhaft, wenn die Wandung des ersten Gehäuses mindestens teilweise Mittel zur Vergrößerung der Wärmeaustauschfläche, insbesondere Rippen oder Rillen aufweist. Gerade im Zusammenwirken mit der Konvektion im Zwischenraum zwischen dem ersten und zweiten Gehäuse kann so eine effiziente Wärmeabgabe erreicht werden.

Eine weitere Verbesserung der Wärmeabgabe wird dadurch erreicht, dass im ersten Gehäuse ein zweites Ventilatormittel zur Erzeugung einer Konvektion des im ersten Gehäuse befindlichen Gases und / oder ein Heizmmittel angeordnet ist. Das Heizmittel sorgt bei niedrigen Außentemperaturen für einen angemessenen Betrieb des Rechenmittels, der Anzeigemittel oder anderer Aggregate im ersten Gehäuse.

Zur Verringerung einer Aufheizung des ersten Gehäuses ist es ferner vorteilhaft, wenn die Wandung des zweiten Gehäuses mindestens teilweise aus einem Material besteht, dessen thermische Leitfähigkeit geringer ist, als die des ersten Gehäuses. Als Material kann z.B. Kunststoff verwendet werden.

Eine effiziente und einfache Bauform liegt in einer Ausführungsform des Multimediaterminals vor, wenn das binokulare System pro Okular jeweils eine Konvexlinse mit langer Brennweite aufweist. Auch ist es vorteilhaft, wenn die Konvexlinsen mindestens auf einer Seite asphärisch ausgebildet sind. Besonders vorteilhaft ist es, wenn das binokulare System als Kopflupe ausgebildet ist, da damit ein entspanntes Sehen über längere Zeiträume möglich ist.

Zur effektiven Aufstellung des Multimediaterminals im Außenraum ist es vorteilhaft, wenn das Mittel zur Aufstellung im Außenraum als Säule oder Stativ ausgebildet ist.

Eine vorteilhafte Ausführungsform des erfindungsgemäßen Multimediaterminals weist eine Visualisierungsvorrichtung für mindestens einen realen Gegenstand auf. Als reale Gegenstände kommen hier insbesondere Gebäude einer Stadtlandschaft in Betracht. Ein Visiermittel, dass hier das Multimediaterminal darstellt, ist beweglich an einer ortsfesten Lagerungsvorrichtung angeordnet, so dass das Visiermittel räumlich auf einen realen Gegenstand ausrichtbar ist.

Ferner weist das Multimediaterminal ein Lageerfassungsmittel zur Erfassung der räumlichen Ausrichtung des Visiermittels auf, wobei durch das Rechenmittel mindestens ein vorab gespeichertes Speicherbild in Korrelation zur räumlichen Ausrichtung des Visiermittels auf dem Anzeigemittel, insbesondere automatisch, anzeigbar ist.

Ein solcher Gegenstand ist dazu bestimmt, auch bei widrigen Witterungsbedingungen lange Zeit im Außenraum aufgestellt zu sein.

Ein Visiermittel, das beweglich an einer ortsfesten Lagerungsvorrichtung angeordnet ist, dient dazu, auf einen realen Gegenstand ausgerichtet zu werden.

Unter einem Visiermittel wird hier jede Vorrichtung verstanden, die räumlich auf einen realen Gegenstand ausgerichtet werden kann, so dass zwischen dem Visiermittel und dem realen Gegenstand eine räumlich eindeutige Beziehung besteht. Ein Visiermittel im Sinne der Erfindung ist z.B. eine Peilvorrichtung. Ein Lageerfassungsmittel dient der Erfassung der räumlichen Ausrichtung des Visiermittels auf den realen Gegenstand. Ein Rechenmittel dient der Steuerung einer Anzeige mindestens eines vorab gespeicherten Speicherbilds auf dem Anzeigemittel, wobei das Speicherbild in Korrelation von der räumlichen Ausrichtung des Visiermittels insbesondere automatisch auswählbar ist.

Ein Speicherbild im Sinne dieser Erfindung ist jede Art einer visuellen Information, wie z.B. ein Foto, ein virtuelles Bild oder eine Videosequenz.

Das Speicherbild ist der Ausrichtung des Visiermittels räumlich korreliert, so dass ein Betrachter das zur realen Ansicht perspektivisch passende Speicherbild auf dem Anzeigemittel sieht. Durch die Kopplung des Visiermittels und der Anzeige des vorab gespeicherten Speicherbildes wird die Datenverarbeitung vereinfacht, da keine Berechnungen z.B. für Überblendungen, Teilintegration von Informationen in das Bild oder die Berechnung eines augmented-reality Bildes notwendig sind. Dadurch werden die Kosten für die Vorrichtung gesenkt und es ist möglich, die gesamte Vorrichtung robust zu gestalten, so dass diese auch für längere Zeit ohne Wartung im Außenraum aufgestellt werden kann. Die Vorteile kommen bei der Aufstellung im Außenraum besonders zum Tragen.

In einer vorteilhaften Ausgestaltung des erfindungsgemäßen Multimediaterminals ist die Korrelation zwischen der Ausrichtung des Visiermittels und mindestens einem Speicherbild in Form einer Tabelle und / oder eines funktionellen Zusammenhangs im Rechenmittel gespeichert. Damit lässt sich die Auswahl des räumlich richtigen Speicherbilds beschleunigen und vereinfachen.

In einer ebenfalls vorteilhaften Ausgestaltung des erfindungsgemäßen Multimediaterminals ist das Visiermittel an der Lagerungsvorrichtung um mindestens eine Achse drehbar und /oder entlang einer Achse verschiebbar angeordnet. Damit kann ein bestimmter Winkelbereich einer realen Ansicht über das Visiermittel angepeilt werden, so dass sich Speicherbilder zu verschiedenen realen Gegenständen anzeigen lassen. Dabei ist es besonders vorteilhaft, wenn das Lageerfassungsmittel die Ausrichtung des Visiermittels über mindestens einen Drehwinkelgeber erfasst, da diese einfach und robust aufgebaut sind.

Besonders vorteilhaft ist es, wenn das Visiermittel ein optisches System zur Aufnahme mindestens eines realen Gegenstandes aufweist. Unter einem optischen System wird hier jedes Mittel verstanden, das geeignet ist, einen realen Gegenstand für einen Betrachter beobachtbar zu machen.

Dabei ist es besonders vorteilhaft, wenn das optische System mindestens eine CCD-Kamera aufweist, deren Bild auf dem Anzeigemittel darstellbar ist.

Eine vorteilhafte Ausgestaltung des erfindungsgemäßen Multimediaterminals weist ein Umschaltmittel zur manuellen Umschaltung zwischen realer Ansicht und mindestens einem Speicherbild auf. Damit kann ein Benutzer auf einfache Weise zwischen der realen Ansicht und dem Speicherbild hin- und herschalten, so dass er beide Ansichten miteinander vergleichen kann.

Vorteilhafterweise verfügt das erfindungsgemäße Multimediaterminal über Auswahlmittel zur Auswahl zur realen Ansicht korrelierter Speicherbilder. Liegen mehrere Speicherbilder zu einer realen Ansicht vor, z.B. aus verschiedenen zweiten, so kann ein Betrachter mit dem Auswahlmittel aus verschiedenen Speicherbildern eine Auswahl treffen.

In vorteilhafter Weise ist mindestens ein Speicherbild als Standbild und / oder eine Abfolge von Bildern, insbesondere als ein Videofilm ausgebildet. Damit lassen sich reale Ansichten besonders wirklichkeitsnah abbilden. Dabei ist es besonders vorteilhaft, wenn mindestens ein Speicherbild eine Darstellung der gleichen realen Ansicht in der Vergangenheit und / oder eine virtuelle Ansicht der realen Ansicht ist. Damit lassen sich in einfacher Weise virtuelle Zeitreisen realisieren.

Mit Vorteil weist ein erfindungsgemäßes Multimediaterminal ein Mittel zum Zoomen für die reale Ansicht und / oder mindestens eines Speicherbilds auf.

Auch ist es vorteilhaft, wenn die Stromversorgung einer Ausführungsform des erfindungsgemäßen Multimediaterminals über ein Stromkabel, Batterien und / oder eine Solarstromanlage erfolgt.

Die Erfindung wird nachfolgend unter Bezugnahme auf die Figuren der Zeichnungen an mehreren Ausführungsbeispielen näher erläutert. Es zeigen:
- Fig. 1: eine schematische Darstellung einer Ausführungsform
- Fig. 2: des erfindungsgemäßen Multimediaterminals mit einem Mittel zur stationären Aufstellung im Außenraum; eine schematische Darstellung der Temperierung einer Ausführungsform des Multimediaterminals;
- Fig. 3: eine schematische Darstellung der Temperierung einer weiteren Ausführungsform des Multimediaterminals;
- Fig. 4a-c: eine schematische Darstellung einer Ausführungsform des Multimediaterminals;
- Fig. 5: eine schematische Darstellung eines optischen Systems einer Ausführungsform des erfindungsgemäßen Multimediaterminals.

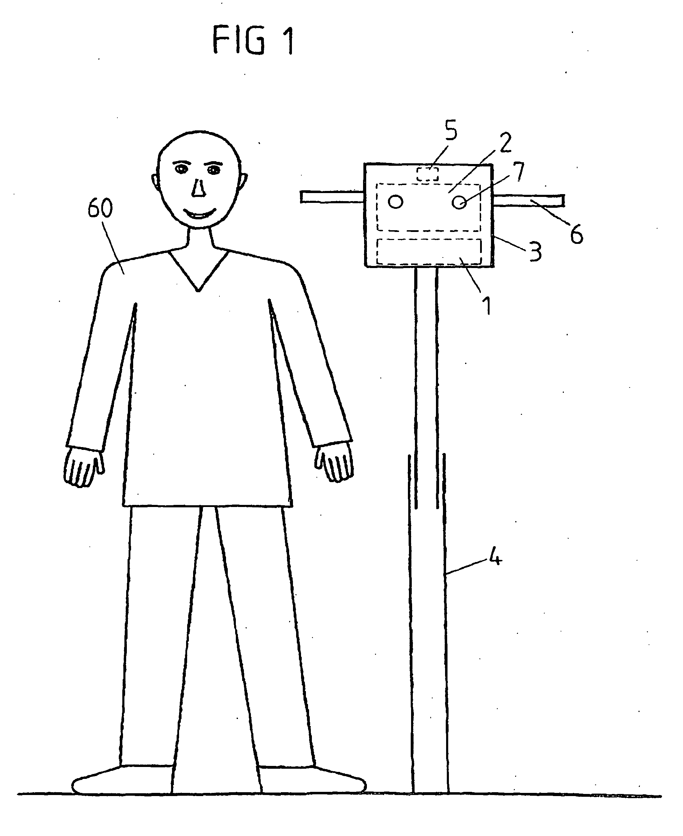

In Fig. 1 ist eine Ausführungsform des erfindungsgemäßen Multimediaterminals dargestellt, die stationär im Außenraum aufgestellt ist. Im Folgenden wird eine Anwendung beschrieben, bei der ein Benutzer 60 mittels des Multimediaterminals 3, das hier im Wesentlichen ein Visiermittel 3 einer Visualisierungsvorrichtung aufweist, die Umgebung betrachten kann und dabei zusätzliche Informationen erhält.

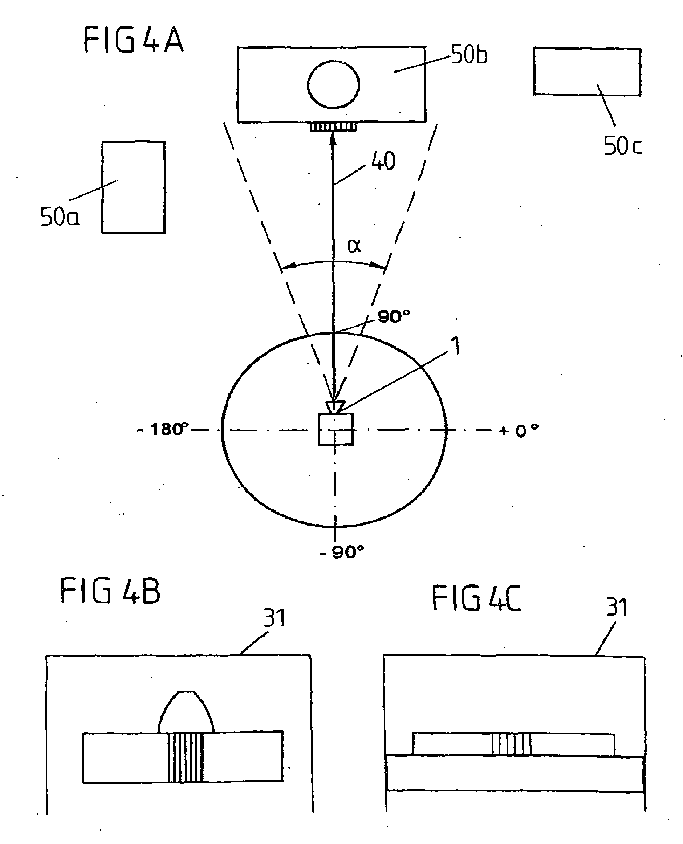

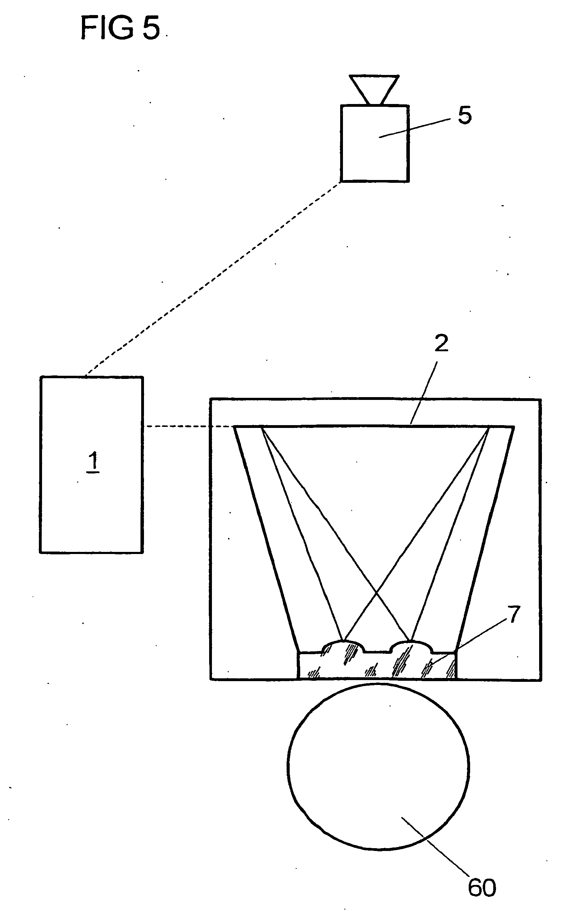

Bilder aus der Umgebung werden dabei mittels eines optischen Systems 5 aufgenommen (in Fig. 1 auf der abgewandten Seite des Visiermittels 3 angeordnet, Details in Fig. 4 und 5) und auf einem Anzeigemittel 2 angezeigt. Das Anzeigemittel 2 wiederum ist für den Benutzer 60 durch ein binokulares System 7 betrachtbar.

Das Visiermittel 3 mit einem integrierten Rechenmittel 1 (hier gestrichelt dargestellt) ist auf einer Lagerungsvorrichtung 4 angeordnet. Das Rechenmittel 1 ist hier als Mikrocomputer ausgebildet, bei dem für später noch zu erläuternde Zwecke Speicherbilder 32 auf einem Datenträger (z.B. CD-ROM, Festplattenspeicher, DVD) gespeichert sind. Das Rechenmittel 1 ist mit dem Anzeigemittel 2 gekoppelt und steuert dieses.

Das Visiermittel 3 weist einen rotatorischen Freiheitsgrad auf, da es um die Längsachse der Lagerungsvorrichtung 4 drehbar ist; d.h. das Visiermittel 3 ist in einer horizontalen Ebene verschwenkbar. Grundsätzlich sind auch andere Lagerungsarten mit mehr rotatorischen und / oder translatorischen Freiheitsgraden möglich.

Die Lagerungsvorrichtung 4 ist hier als eine Art Säule ausgebildet, die ein Mittel zur stationären Aufstellung des Multimediaterminals (hier des Visiermittels 3) darstellt. Die Lagerungsvorrichtung 4 ist im Boden verankert, so dass sie standsicher ist.

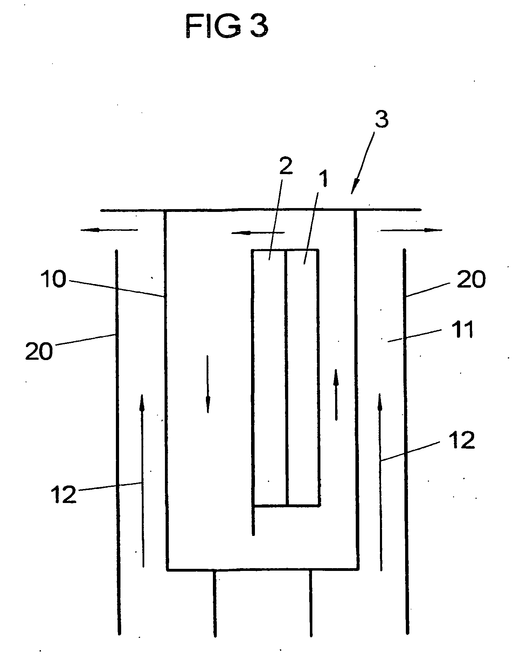

Das Visiermittel 3 weist als optisches System 5 eine digitale Kamera, hier eine CCD-Kamera, auf, dessen Ausrichtung 40 (siehe Fig. 3a) mit der zentralen Blickrichtung für einen Benutzer 60 durch das Visiermittel 3 zusammen fällt.

Mit Hilfe des optischen Systems 5 ist es möglich, reale Ansichten 31 (siehe Fig. 4) aufzunehmen, die dann mit den Speicherbildern 32 vergleichbar sind.

An dem Visiermittel 3 ist seitlich je ein Bedienelement 6 angeordnet, mit dem das Visiermittel 3 vom Benutzer 60 um die Längsachse der Lagerungsvorrichtung 4 gedreht werden kann. Damit kann ein Benutzer 60 das Visiermittel 3 über einen Vollkreis verschwenken. Alternativ verfügt das Visiermittel 3 über Antriebe, die eine automatische oder zuschaltbare Verschwenkung des Visiermittels 3 erlauben, so dass ein Benutzer 60 nicht die Hände zum Bedienen der Vorrichtung benötigt. Mit einer geeigneten Steuerung ist eine automatische Bedienung (z.B. automatisierte Schwenks des Visiermittels 3) möglich.

In einer alternativen Ausgestaltung weist das optische System 5 eine digitale Kamera (siehe Fig. 4a) auf, die eine reale Ansicht 31 speichern kann. Die Aufnahmen werden an das Rechenmittel 1 übertragen, mit einer Positions- und Zeitmarkierung versehen und dann als neue Speicherbilder 32 gespeichert. Damit ist es möglich, dass die Ausführungsform des erfindungsgemäßen Multimediaterminals in der Lage ist, selbständig Speicherbilder 32 zu generieren, die von einem Benutzer 60 anwählbar sind.

In Fig. 1 ist ein optisches System 5 dargestellt, bei dem die Betrachtung der realen Ansicht 31 und des Speicherbildes 32 in einer Vorrichtung erfolgt (siehe Fig. 4); d.h. das Anzeigemittel 2 für die von der Kamera 5 aufgenommene reale Ansicht 31 und das Speicherbild 32 ist im gleichen Gehäuse wie das optische System 5 untergebracht. Ein Benutzer 60 sieht die reale Ansicht 31 und das Speicherbild 32 im selben Gerät, so dass ein besonders intensiver Vergleich der beiden Ansichten möglich ist, da der Kopf zwischen den Ansichten nicht bewegt werden muss; die Bilder werden vor seinen Augen ausgetauscht.

In alternativen Ausgestaltungen ist das Anzeigemittel 2 getrennt von dem Visiermittel 3 ausgebildet. Eine besonders robuste und kostengünstige Ausgestaltung besteht aus einer drehbaren, mechanischen Peileinrichtung (z.B. einem Drehknopf), die auf einen realen Gegenstand 50a, 50b, 50c ausrichtbar ist. Das Speicherbild 32 wird dazu auf einem Display als Anzeigemittel 2 dargestellt. Somit kann ein Benutzer 60 die reale Ansicht 31 ohne Hilfsmittel mit seinen Augen betrachten und das korrelierte Speicherbild 32 auf dem Display betrachten. Das Display kann dabei z.B. in einem Gebäude oder einer Mauer angeordnet sein, so dass sich eine besonders robuste Ausgestaltung ergibt.

In Fig. 1 ist erkennbar, dass die Visiereinrichtung 3 mit dem integrierten Rechenmittel 1 den Umgebungseinflüssen ausgesetzt ist. Sonnenstrahlung sorgt dafür, dass die Temperatur im Inneren des Visiermittels 3 stark ansteigt. Daher ist das Gehäuse des Multimediaterminals (Visiermittel 3) gemäß der Erfindung in einer besonderen Weise ausgestaltet.

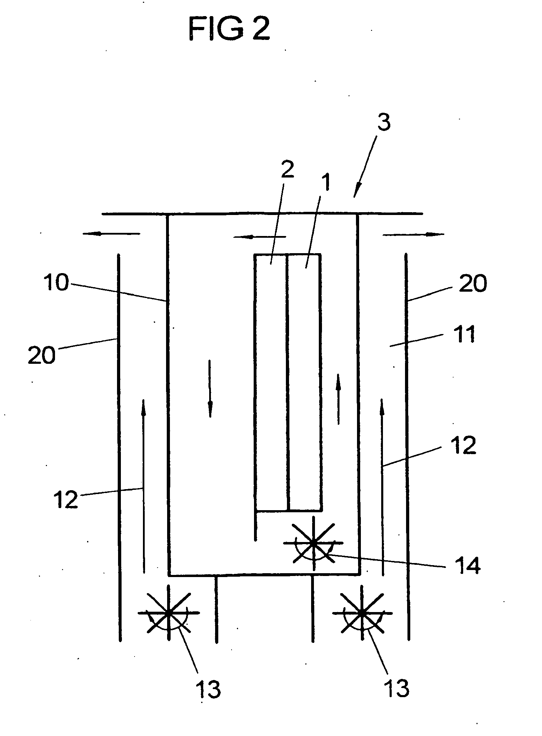

In Fig. 2 ist bei einer Ausfürhungsform schematisch dargestellt, dass das Rechenmittel 1 und das damit gekoppelte Anzeigemittel 2 in einem ersten Gehäuse 10 angeordnet sind, wobei das erste Gehäuse 10 wasser- und staubdicht gegenüber der Umgebung abgeschlossen ist. Zum Schutz vor Kälte kann im Inneren des ersten Gehäuses (10) ein hier nicht dargestelltes Heizmittel angeordnet sein. Es kann auch ein Peltierelement vorgesehen sein.

In das erste Gehäuse 10 eintretende Kabel werden entsprechend abgedichtet. Im Inneren des ersten Gehäuses 10 ist ein erstes Ventilatormittel 13 angeordnet, dass für eine erzwungene Konvektion innerhalb des ersten Gehäuses 10 sorgt. Allein dadurch wird eine gewisse Kühlung des Rechenmittels 1 und des Anzeigemittel 2 erreicht.

Des Weiteren ist das erste Gehäuse 10 so ausgebildet, dass die Wandung teilweise oder vollständig aus einem Material mit hoher Wärmeleitfähigkeit, z.B. Kupfer oder Aluminium besteht. Dadurch kann Wärme leicht abgeführt werden. Zusätzlich oder alternativ kann das erste Gehäuse 10 Rillen, Rippen, Noppen oder andere Mittel zur Vergrößerung der Oberfläche aufweisen. Je größer die Oberfläche zur Wärmeübertragung ist, desto besser kann die Wärme abgeführt werden.

Das erste Gehäuse 10 ist teilweise von einem zweiten Gehäuse 20 umgeben, das Sonnenstrahlung, Regen und andere Umwelteinflüsse vom ersten Gehäuse 10 abhält. Zwischen dem ersten Gehäuse 10 und dem zweiten Gehäuse 20 ist ein Zwischenraum 11 angeordnet, in dem Umgebungsluft konvektiv bewegt werden kann.

Im dargestellten Ausführungsbeispiel dient ein zweites Ventilatormittel 14 (hier mit zwei Gebläsen) dazu, Umgebungsluft von unten in den Zwischenraum 11 zu blasen, so dass die am ersten Gehäuse 10 erhitzte Luft als Gasstrom 12 mit erzwungener Konvektion nach oben entweichen kann.

In Fig. 3 ist grundsätzlich die gleiche Ausführungsform, wie in Fig. 2 dargestellt. Im Unterschied dazu wird bei der Ausführungsform gemäß Fig. 2 der Gasstrom 12 im Zwischenraum 11 mittels natürlicher Konvektion bewegt.

Damit ist es grundsätzlich möglich, auf das zweite Ventilatormittel 14 zu verzichten, wenn die natürliche Konvektion, bedingt durch die Temperaturverteilung im Zwischenraum 11, so groß ist, dass ein natürlicher Luftzug im Zwischenraum 11 entsteht. Grundsätzlich können natürliche und erzwungene Konvektion auch in Kombination verwendet werden.

Eine mögliche Ausgestaltung des Zwischenraums 11 ist die Anordnung zweier flacher Kanäle an den Seiten des Mulitmediaterminals. Wenn das Mulitmediaterminal als längliches Gehäuse entlang der Lagerungsvorrichtung ausgebildet ist, können jeweils Kanäle von 70 cm verwendet werden.

Die Breite der Kanäle beträgt dann z.B. 15 bis 20 cm. Diese Breite reicht aus, am oberen Ende des Mulitmediaterminals ein Anzeigemittel 2 und das optische System 5 anzuordnen.

Die Tiefe der Kanäle beträgt ca. 1 cm, so dass im Ganzen die Zwischenräume 11 den Charakter eines Flachkanals haben, der insbesondere gut für die Erzeugung einer natürlichen Konvektion geeignet ist. Die gleichen Abmessungen können aber auch mit dem zweiten Ventilatormittel 14 verwendet werden.

In den Ausführungsformen gemäß Fig. 2 und 3 besteht das zweite Gehäuse 20 wenigstens teilweise aus einem Material mit einer thermischen Wärmeleitfähigkeit, die geringer ist als die des ersten Gehäuses.

Damit heizt sich das Material bei Sonnenbestrahlung stärker auf und schützt damit das erste Gehäuse 10 vor einer direkten Aufheizung.

Das Rechenmittel 1 verfügt über eine Steuersoftware, mit der die Temperierung mittels der Konvektion (oder auch des Heizmittels im ersten Gehäuse 10) automatisch angepasst wird, so dass das Rechenmittel 1 und das Anzeigemittel 2 richtig temperiert werden. Dazu steuert das Rechenmittel 1 die Ventilatormittel 13, 14 und schaltet gegebenenfalls das Heizmittel dazu.

In Fig. 4a, 4b, 4c ist das Funktionsprinzip einer Ausführungsform des erfindungsgemäßen Multimediaterminals (siehe Fig. 1) dargestellt.

Ein Visiermittel 3 (siehe Fig. 4a) dient dazu, einen realen Gegenstand 50a, 50b, 50c "anzupeilen", indem das Visiermittel 1 in die Richtung des realen Gegenstandes 50a, 50b, 50c gedreht wird.

Das Visiermittel 3 weist als optisches System 5 eine digitale Kamera (siehe Fig. 5) auf, die reale Gegenstände 50a, 50b, 50c aufnehmen kann. Unter einem optischen System 5 wird jedes Mittel verstanden, das geeignet ist, einen realen Gegenstand 50a, 50b, 50c für einen Benutzer 60 beobachtbar zu machen. Dabei kann die Ansicht z.B. verkleinert, vergrößert oder verzerrt werden, um z.B. einen größeren Blickwinkel zu haben (Fischauge). Auch ein Wechsel zwischen verschiedenen Betrachtungsarten (z.B. Umschalten von Weitwinkel- auf Teleoptik) ist für bestimmte Anwendungen sinnvoll. Bei manchen Ansichten wird keine optische Veränderung der Ansicht erforderlich sein, so dass das optische System 5 die Ansicht im wesentlichen so wiedergibt, wie der Benutzer 60 sie mit dem bloßen Auge wahrnimmt.

Das optische System 5 weist im vorliegenden Fall eine CCD Kamera auf; deren aufgenommenes Bild auf dem Anzeigemittel 2 unter Steuerung des Rechenmittels 1 dargestellt wird. Das Anzeigemittel 2 wiederum ist durch ein Okular 7 betrachtbar, das in Form einer Lupe das Bild auf dem Anzeigemittel vergrößert.

Alternativ sind z.B. auch Fernrohre als Teile des optischen Systems 5 einsetzbar.

Eine alternative Ausgestaltung des Visiermittels 3 weist eine mechanische Peilvorrichtung auf, die auf einen realen Gegenstand 50a, 50b, 50c ausgerichtet werden kann. Auch kann ein einfacher Drehknopf oder ein Schieberegler mit einer Skala dazu dienen, eine räumliche Korrelation zwischen der Position des Visiermittels 3 und dem realen Gegenstand 50a, 50b, 50c herzustellen. Ein Drehknopf würde dann z.B. einen Pfeil aufweisen, den ein Benutzer in Richtung des realen Gegenstands 50a, 50b, 50c drehen könnte.

Das Visiermittel 3 ist hier mit einem optischen System 5 ausgestattet, bei dem die räumliche Ausrichtung 40 und die Blickrichtung durch das optische System 5 zusammen fallen, d.h. ein Benutzer 60 kann einen realen Gegenstand 50a, 50b, 50c durch das Visiermittel 3 entlang der Ausrichtung 40 anpeilen.

In der dargestellten Situation sollen die realen Gegenstände 50a, 50b, 50c Gebäude sein, die aus einiger Entfernung mit dem Visiermittel 3 betrachtet werden. Das optische System 5 des Visiermittels 3 verfügt über einen gewissen Öffnungswinkel α, so dass jeweils ein Teil der Gebäude 50a, 50b, 50c vom optischen System 5 erfassbar ist. Die Ausrichtung 2 ist hier die Winkelhalbierende des Öffnungswinkels α.

Die Ansicht, die sich einem Benutzer 60 durch das optische System 5 bietet, ist in Fig. 3b dargestellt; es zeigt die reale Ansicht 31 eines Gebäudes 50b.

Die Ausrichtung 40 des Visiermittels 3 wird durch ein hier nicht dargestelltes Lageerfassungsmittel erfasst. Dabei wird der Drehwinkel des Visiermittels 3 in der Zeichnungsebene erfasst. Der Drehwinkel ist hier als Vollkreis in einem kartesischen Koordinatensystem dargestellt. Da das hier anvisierte Gebäude 50b genau vor dem Visiermittel 3 liegt, beträgt der Drehwinkel, der der hier dargestellten Ausrichtung 40 zugeordnet ist, 90°. Da das Visiermittel 3 ortsfest aufgestellt ist, ist es nicht notwendig, die Koordinaten des Visiermittels 3 zu berechnen, so dass die notwendige. Datenverarbeitung sehr effizient und robust ist.

Das Multimediaterminal weist ein hier nicht dargestelltes Rechenmittel 1 auf, in dem eine Tabelle mit der Zuordnung Drehwinkel-Speicherbild gespeichert ist, so dass zu bestimmten Drehwinkeln jeweils ein gespeichertes Bild, ein Speicherbild 32, automatisch ausgewählt wird. Durch die Speicherung in einer Tabelle werden aufwendige Umrechnungsarbeiten vermieden. Alternativ kann statt einer Tabelle ein fester funktionaler Zusammenhang gespeichert werden, der eine schnelle Zuordnung von räumlicher Ausrichtung 40 und Speicherbild 32 erlaubt.

Das Speicherbild 32 wird dann auf dem Anzeigemittel 2 (siehe Fig. 5) anstelle der realen Ansicht 31 angezeigt; die reale Ansicht 31 wird durch das Speicherbild 32 ausgetauscht.

Für den bloßen Austausch der realen Ansicht 31 durch das Speicherbild 32 sind keine umfangreichen Umrechnungen notwendig, die z.B. bei einer Überblendung zweier Bilder erforderlich wären.

Ein Speicherbild 32 ist hier ein Standbild. Alternativ kann das Speicherbild 32 eine Filmsequenz sein.

Die Anzeige des Speicherbilds 32 erfolgt z.B. automatisch, nachdem das Visiermittel 3 eine bestimmte Zeit auf einem Drehwinkel verharrte. Auch kann die Anzeige des Speicherbildes 32 durch eine Benutzeraktion (z.B. einen Tastendruck) ausgelöst werden.

Das Speicherbild 32 zeigt hier einen Zustand, der mit der realen Ansicht 31 nicht übereinstimmt, nämlich eine historische Ansicht. Diese historische Ansicht ist so gewählt, dass die gleiche räumliche Perspektive vorliegt wie bei der realen Ansicht 31. Ein Benutzer 60 kann somit die reale Ansicht 31 mit der historischen Ansicht des Speicherbilds 32 vergleichen.

In hier nicht dargestellter Weise verfügt das Multimediaterminal über Umschaltmittel, z.B. in Form eines Bedienelementes, mit dem zum schnellen Vergleich schnell manuell zwischen der realen Ansicht 31 (siehe Fig. 4b) und dem Speicherbild 32 (siehe Fig. 4c) hin und her geschaltet werden kann.

Durch ein ebenfalls hier nicht dargestelltes Auswahlmittel (z.B. einen Dreh- oder Schieberegler) kann ein Benutzer zwischen verschiedenen Speicherbildern 32, die perspektivisch der realen Ansicht 31 entsprechen, wählen. So können z.B. Speicherbilder 32, die zu verschiedenen Zeiten aufgenommen wurden, durch das Auswahlmittel hintereinander angezeigt werden, so dass eine Art Zeitreise entsteht.

Auch verfügt das Multimediaterminal über ein akustisches System, das zu der jeweiligen Ausrichtung 40 und dem angezeigten Speicherbild 32 korrelierte akustische Informationen abstrahlt.

Somit lässt sich auf wirtschaftliche Weise ein robustes Multimediasystem aufbauen, das auf Grund der Temperiervorrichtung (siehe Fig. 2 oder Fig. 3) insbesondere für die Aufstellung im Außenraum geeignet ist.

Dabei wurde die Anwendung hier anhand eines touristischen Beispiels erläutert. Grundsätzlich sind aber die erfindungsgemäßen Multimediaterminals geeignet, zu anderen Einsatzzwecken im Außenraum für längere Zeit aufgestellt zu werden. Eine weitere Möglichkeit wäre die Verwenung im Rahmen eines Leit- oder Informationssystems im Außenraum. Auch eine Verwendung zu Unterhaltungszwecken und / oder im Zusammenhang einer Ausstellung von Kulturgütern ist denkbar.

In Fig. 5 ist schematisch ein Benutzer 60 dargestellt, der durch ein binokulares System 7 das Anzeigemittel 2, hier in Form eines LCD-Displays, betrachtet.

Auf dem Anzeigemittel 2 werden reale Ansichten 31 dargestellt, die von der Kamera 5 aufgenommen werden. Das Rechenmittel 1 steuert die Anzeige und ggf. die Einblendung von Speicherbildern 32.

Das binokulare System 7 ist dabei in Form einer Kopflupe ausgebildet, deren einteilige Linsen asphärisch geschliffen sind. Die einteilige Linse hat im Wesentlichen die Form eines Quaders, wobei die dem Benutzer 60 zugewandte Seite flach ausgebildet ist. Aus Gründen der Deutlichlichkeit ist die Breite des Bauteils hier dicker dargestellt, als in der Realität notwendig. Der Dicke des flachen Teils beträgt ca. 0,5 cm.

Die asphärisch geschliffenen Teile sind an der dem Benutzer 60 abgewandten Seite angeordnet, d.h. sie ragen in das Innere des Multimediaterminals. Somit ergibt sich ein Bauteil mit zwei angeformten, konvexen Bereichen als Lupen. Es liegt grundsätzliche eine plankonvexe Lupenkonstruktion vor. Ein solches Bauelement ist besonders robust ausführbar, was für die Aufstellung im Außenraum wichtig ist.

Damit ist es möglich, das Anzeigemittel 2 vergrößert zu betrachten.

Die Erfindung beschränkt sich in ihrer Ausführung nicht auf die vorstehend angegebenen bevorzugten Ausführungsbeispiele. Vielmehr ist eine Anzahl von Varianten im Rahmen des Schutzumfangs der beigefügten Ansprüche denkbar, die vom erfindungsgemäßen Multimediaterminal auch bei grundsätzlich anders gearteten Ausführungen Gebrauch machen.

### Bezugszeichenliste

- 1: Rechenmittel
- 2: Anzeigemittel
- 3: Visiermittel (Multimediaterminal)
- 4: Lagerungsvorrichtung
- 5: optisches System (digitale Kamera)
- 6: Bedienelement
- 7: binokulares System

- 10: erstes Gehäuse
- 11: Zwischenraum
- 12: konvektiver Gasstrom
- 13: erstes Ventilatormittel
- 14: zweites Ventilatormittel
- 20: zweites Gehäuse

- 31: reale Ansicht
- 32: Speicherbild

- 40: räumliche Ausrichtung

- 50a, b, c: reale Gegenstände

- 60: Benutzer

## Patentansprüche

1. Multimediaterminal mit einem Mittel zur stationären Aufstellung im Außenraum und mit einem Rechenmittel (1) und mindestens einem Anzeigemittel (2), wobei das Rechenmittel (1) und/oder das mindestens eine Anzeigemittel (2) in einem ersten Gehäuse (10) angeordnet sind,
**dadurch gekennzeichnet, dass**
- das erste Gehäuse (10) zur Abschirmung gegenüber Umgebungseinflüssen mindestens teilweise von einem zweiten Gehäuse (20) umgeben ist, wobei in mindestens einem Zwischenraum (11) zwischen dem ersten Gehäuse (10) und dem zweiten Gehäuse (20) ein konvektiver Gasstrom (12), insbesondere ein Luftstrom, erzeugbar ist, und
- das Anzeigemittel (2) durch ein binokulares System (7) für einen Benutzer (60) des Multimediaterminals betrachtbar ist, wobei das binokulare System (7) eine einstückige Optik aufweist, deren dem Benutzer (60) zugewandte Seite flach ausgebildet ist und an der dem Benutzer (60) abgewandten Seite im Bereich der Augen jeweils konvexe Bereiche angeformt sind.

2. Multimediaterminal nach Anspruch 1, **dadurch gekennzeichnet, dass** der Gasstrom (12) durch Umgebungsluft gebildet wird, die durch mindestens ein erstes Ventilatormittel (13) angesaugt wird.

3. Multimediaterminal nach Anspruch 1 oder 2, **gekennzeichnet durch** ein Mittel zur Erzeugung einer natürlichen Konvektion in mindestens einem Zwischenraum (11), insbesondere einem Mittel zur Führung eines umgebungsluftzuges in mindestens einem Zwischenraum (11).

4. Multimediaterminal nach mindestens einem der vorhergehenden Ansprüche, **dadurch gekennzeichnet, dass** das erste Gehäuse (10) wasser-, staub- und / oder luftdicht ausgebildet ist.

5. Multimediaterminal nach mindestens einem der vorgehenden Ansprüche, **dadurch gekennzeichnet, dass** die Wandung des ersten Gehäuses (10) mindestens teilweise aus einem Material hoher Wärmeleitfähigkeit, insbesondere einem Metall besteht.

6. Multimediaterminal nach Anspruch 5, **dadurch gekennzeichnet, dass** die Wandung des ersten Gehäuses (10) mindestens teilweise aus Stahl, Aluminium, Messing oder Kupfer besteht.

7. Multimediaterminal nach mindestens einem der vorhergehenden Ansprüche, **dadurch gekennzeichnet, dass** die Wandung des ersten Gehäuses (10) mindestens teilweise Mittel zur Vergrößerung der Wärmeaustauschfläche, insbesondere Rippen oder Rillen aufweist.

8. Multimediaterminal nach mindestens einem der vorhergehenden Ansprüche, **dadurch gekennzeichnet, dass** im ersten Gehäuse (10) ein zweites Ventilatormittel (14) zur Erzeugung einer Konvektion von im ersten Gehäuse (10) befindlichen Gas und / oder ein Heizmittel angeordnet ist.

9. Multimediaterminal nach mindestens einem der vorhergehenden Ansprüche, **dadurch gekennzeichnet dass** die Wandung des zweiten Gehäuses (20) mindestens teilweise aus einem Material besteht, dessen thermische Leitfähigkeit geringer ist als die des ersten Gehäuses (10), insbesondere einem Kunststoff.

10. Multimediaterminal nach mindestens einem der vorhergehenden Ansprüche, **dadurch gekennzeichnet, dass** der Raum zwischen dem binokularen System (7) und dem Anzeigemittel (2) zur Vermeidung von Reflexen schwarz ausgebildet ist.

11. Multimediaterminal nach mindestens einem der vorhergehenden Anspruch, **dadurch gekennzeichnet, dass** das binokulare System (7) pro Okular jeweils eine Konvexlinse mit langer Brennweite aufweist.

12. Multimediaterminal nach Anspruch 11, **dadurch gekennzeichnet, dass** die Konvexlinsen mindestens auf einer Seite asphärisch ausgebildet sind.

13. Multimediaterminal nach mindestens einem der vorhergehenden Ansprüche, **dadurch gekennzeichnet, dass** das binokulare System (7) als Kopflupe ausbildet ist.

14. Multimediaterminal nach mindestens einem der vorhergehenden Ansprüche, **dadurch gekennzeichnet, dass** das Mittel zur Aufstellung im Außenraum als Säule (4) oder Stativ ausgebildet ist.

15. Multimediaterminal nach mindestens einem der vorhergehenden Ansprüche, **dadurch gekennzeichnet, dass**
a) das Multimediaterminal ein Visiermittel (3) für einen realen Gegenstand (50a, 50b, 50c) aufweist, insbesondere für Gebäude einer Stadtlandschaft, und das Visiermittel (3) beweglich an einer ortsfesten Lagerungsvorrichtung (4) angeordnet ist, so dass das Visiermittel (3) räumlich auf einen realen Gegenstand (50a, 50b, 50c) ausrichtbar ist und
b) einem Lageerfaesungsmittel zur Erfassung der räumlichen Ausrichtung (40) des Visiermittels (3), wobei
c) durch das Rechenmittel (1) mindestens ein vorab gespeichertes Speicherbild (32) in Korrelation zur räumlichen Ausrichtung (40) des Visiermittels (3) auf dem Anzeigemittel (2), insbesondere automatisch, anzeigbar ist.

16. Multimediaterminal nach Anspruch 15, **dadurch gekennzeichnet, dass** die Korrelation zwischen Ausrichtung (40) und mindestens einem Speicherbild (32) in Form einer Tabelle und / oder eines funktionellen Zusammenhangs im Rechenmittel (1) gespeichert ist.

17. Multimediaterminal nach Anspruch 15 oder 16, **dadurch gekennzeichnet, dass** das Visiermittel (3) an der Lagerungsvorrichtung (4) um mindestens eine Achse drehbar und / oder entlang einer Achse verschiebbar angeordnet ist.

18. Multimediaterminal nach mindestens einem der Ansprüche 15 bis 17, **dadurch gekennzeichnet, dass** das Lageerfassungsmittel die Ausrichtung (40) des Visiermittels (3) über mindestens einen Drehwinkelgeber erfasst.

19. Multimediaterminal nach mindestens einem der Ansprüche 15 bis 18, **dadurch gekennzeichnet, dass** das Visiermittel (3) ein optisches System (5) zur Aufnahme mindestens eines realen Gegenstandes (50a, 50b, 50c) aufweist.

20. Multimediaterminal nach Anspruch 19, **dadurch gekennzeichnet, dass** das optische System (5) mindestens eine CCD-Kamera aufweist, deren Bild auf dem Anzeigemittel (2) darstellbar ist.

21. Multimediaterminal nach mindestens einem der vorhergehenden Ansprüche, **gekennzeichnet durch** ein Umschaltmittel zur manuellen Umschaltung zwischen realer Ansicht (50a, 50b, 50c) und mindestens einem Speicherbild (32).

22. Multimediaterminal nach mindestens einem der vorhergehenden Ansprüche, **gekennzeichnet durch** ein Auswahlmittel zur Auswahl zur realen Ansicht (50a, 50b, 50c) korrelierter Speicherbilder (32).

23. Multimediaterminal nach mindestens einem der vorhergehenden Ansprüche, **dadurch gekennzeichnet, dass** mindestens ein Speicherbild (32) ein Standbild und / oder eine Abfolge von Bildern, insbesondere ein Videofilm, ist.

24. Multimediaterminal nach mindestens einem der vorhergehenden Ansprüche, **dadurch gekennzeichnet, dass** mindestens ein Speicherbild (32) eine Darstellung der gleichen realen Ansicht (50a, 50b, 50c) in der Vergangenheit und / oder eine virtuelle Ansicht der realen Ansicht (50a, 50b, 50c) ist.

25. Multimediaterminal nach mindestens einem der vorhergehenden Ansprüche, **gekennzeichnet durch** ein Mittel zum Zoomen für die reale Ansicht (50a, 50b, 50c) und /oder für mindestens ein Speicherbild (32).

26. Multimediaterminal nach mindestens einem der vorhergehenden Ansprüche, **dadurch gekennzeichnet, dass** eine Stromversorgung über ein Stromkabel, Batterien und / oder eine Solarstromanlage erfolgt.

## Claims

1. A multimedia terminal with a means for installing outside in a stationary manner and with a computing means (1) and at least one display means (2), wherein the computing means (1) and the at least one display means (2) are arranged in a first housing (10),
**characterized in that**
- for shielding against environmental influences, the first housing (10) is at least partly surrounded by a second housing (20), wherein in at least one space (11) between the first housing (10) and the second housing (20) a convective gas flow (12), in particular an air flow, can be generated, and
- the display means (2) can be viewed through a binocular system (7) for a user (60) of the multimedia terminal, wherein the binocular system (7) includes an integral optical system whose side facing the user (60) is flat and on whose side facing away from the user (60) convex regions each are integrally formed in the region of the eyes.

2. The multimedia terminal according to claim 1, **characterized in that** the gas flow (12) is formed by ambient air which is sucked in through at least one first fan means (13).

3. The multimedia terminal according to claim 1 or 2, **characterized by** a means for generating a natural convection in at least one space (11), in particular a means for guiding an ambient air draft in at least one space (11).

4. The multimedia terminal according to at least one of the preceding claims, **characterized in that** the first housing (10) is water-, dust- and/or air-tight.

5. The multimedia terminal according to at least one of the preceding claims, **characterized in that** the wall of the first housing (10) is at least partly made of a material of high thermal conductivity, in particular of a metal.

6. The multimedia terminal according to claim 5, **characterized in that** the wall of the first housing (10) is at least partly made of steel, aluminum, brass or copper.

7. The multimedia terminal according to at least one of the preceding claims, **characterized in that** the wall of the first housing (10) at least partly includes means for increasing the heat exchange surface, in particular ribs or grooves.

8. The multimedia terminal according to at least one of the preceding claims, **characterized in that** in the first housing (10) a second fan means (14) for generating a convection of gas present in the first housing (10) and/or a heating means is arranged.

9. The multimedia terminal according to at least one of the preceding claims, **characterized in that** the wall of the second housing (20) is at least partly made of a material whose thermal conductivity is smaller than that of the first housing (10), in particular of a plastic material.

10. The multimedia terminal according to at least one of the preceding claims, **characterized in that** the space between the binocular system (7) and the display means (2) is black, in order to avoid reflections.

11. The multimedia terminal according to at least one of the preceding claims, **characterized in that** the binocular system (7) includes one convex lens with long focal length for each eyepiece.

12. The multimedia terminal according to claim 11, **characterized in that** the convex lenses are aspherical on at least one side.

13. The multimedia terminal according to at least one of the preceding claims, **characterized in that** the binocular system (7) constitutes a head magnifier.

14. The multimedia terminal according to at least one of the preceding claims, **characterized in that** the means for installing outside constitutes a pillar (4) or stand.

15. The multimedia terminal according to least one of the preceding claims, **characterized in that**
a) the multimedia terminal includes a sighting means (3) for a real object (50a, 50b, 50c), in particular for buildings of an urban landscape, and the sighting means (3) is movably arranged on a stationary bearing means (4), so that the sighting means (3) can be spatially aligned with a real object (50a, 50b, 50c), and
b) a position detection means for detecting the spatial orientation (40) of the sighting means (3), wherein
c) by means of the computing means (1) at least one pre-stored memory image (32) can be displayed on the display means (2), in particular automatically, in correlation with the spatial orientation (40) of the sighting means (3).

16. The multimedia terminal according to claim 15, **characterized in that** the correlation between orientation (40) and at least one memory image (32) is stored in the computing means (1) in the form of a table and/or a functional relationship.

17. The multimedia terminal according to claim 15 or 16, **characterized in that** the sighting means (3) is arranged on the bearing means (4) so as to be rotatable about at least one axis and/or movable along an axis.

18. The multimedia terminal according to at least one of claims 15 to 17, **characterized in that** the position detection means detects the orientation (40) of the sighting means (3) via at least one rotary encoder.

19. The multimedia terminal according to at least one of claims 15 to 18, **characterized in that** the sighting means (3) includes an optical system (5) for recording at least one real object (50a, 50b, 50c).

20. The multimedia terminal according to claim 19, **characterized in that** the optical system (5) includes at least one CCD camera whose image can be represented on the display means (2).

21. The multimedia terminal according to at least one of the preceding claims, **characterized by** a switching means for manually switching between real view (50a, 50b, 50c) and at least one memory image (32).

22. The multimedia terminal according to at least one of the preceding claims, **characterized by** a selecting means for selecting memory images (32) correlated for real view (50a, 50b, 50c).

23. The multimedia terminal according to at least one of the preceding claims, **characterized in that** at least one memory image (32) is a still image and/or a sequence of images, in particular a video film.

24. The multimedia terminal according to at least one of the preceding claims, **characterized in that** at least one memory image (32) is a representation of the same real view (50a, 50b, 50c) in the past and/or a virtual view of the real view (50a, 50b, 50c).

25. The multimedia terminal according to at least one of the preceding claims, **characterized by** a means for zooming for the real view (50a, 50b, 50c) and/or for at least one memory image (32).

26. The multimedia terminal according to at least one of the preceding claims, **characterized in that** a power supply is effected via a power cable, batteries and/or a solar power system.

## Revendications

1. Terminal multimédia doté d'un moyen qui permet de le placer en position stationnaire à l'extérieur et d'un moyen de calcul (1) et d'au moins un moyen d'affichage (2), le moyen de calcul (1) et d'au moins le moyen d'affichage (2) étant disposés dans un premier boîtier (10),
**caractérisé en ce que**
- le premier boîtier (10) est entouré au moins en partie par un deuxième boîtier (20) pour protéger contre les influences de l'environnement, un écoulement convectif (12), en particulier un écoulement d'air, pouvant être établi dans au moins un espace intermédiaire (11) situé entre le premier boîtier (10) et le deuxième boîtier (20),
- le moyen d'affichage (2) pouvant être observé à l'aide d'un système binoculaire (7) par un utilisateur (60) du terminal multimédia, le système binoculaire (7) présentant une optique d'une seule pièce dont le côté tourné vers l'utilisateur (60) est plat et des parties convexes étant formées sur le côté non tourné vers l'utilisateur (60) dans la zone occupée par les yeux.

2. Terminal multimédia selon la revendication 1, **caractérisé en ce que** l'écoulement de gaz (12) est formé par de l'air ambiant qui est aspiré par au moins un premier moyen à ventilateur (13).

3. Terminal multimédia selon la revendication 1 ou 2, **caractérisé par** un moyen de formation d'une convection naturelle dans au moins un espace intermédiaire (11) et en particulier par un moyen qui guide un écoulement d'air ambiant dans au moins un espace intermédiaire (11).

4. Terminal multimédia selon au moins l'une des revendications précédentes, **caractérisé en ce que** le premier boîtier (10) est étanche à l'eau, à la poussière et/ou à l'air.

5. Terminal multimédia selon au moins l'une des revendications précédentes, **caractérisé en ce qu'**au moins une partie de la paroi du premier boîtier (10) est constituée d'un matériau à haute conductivité thermique, en particulier d'un métal.

6. Terminal multimédia selon la revendication 5, **caractérisé en ce qu'**au moins une partie de la paroi du premier boîtier (10) est réalisée en acier, en aluminium, en laiton ou en cuivre.

7. Terminal multimédia selon au moins l'une des revendications précédentes, **caractérisé en ce qu'**au moins certaines parties de la paroi du premier boîtier (10) présentent des moyens d'agrandissement de la surface d'échange thermique, en particulier des nervures ou des rainures.

8. Terminal multimédia selon au moins l'une des revendications précédentes, **caractérisé en ce qu'**un deuxième moyen à ventilateur (14) qui forme une convection dans le gaz présent dans le premier boîtier (10) et/ou un moyen de chauffage sont disposés dans le premier boîtier (10).

9. Terminal multimédia selon au moins l'une des revendications précédentes, **caractérisé en ce qu'**au moins une partie de la paroi du deuxième boîtier (20) est constituée d'un matériau dont la conductivité thermique est inférieure à celle du premier boîtier (10), et en particulier d'une matière synthétique.

10. Terminal multimédia selon au moins l'une des revendications précédentes, **caractérisé en ce que** l'espace situé entre le système binoculaire (7) et le moyen d'affichage (2) est réalisé en noir pour éviter les réflexions.

11. Terminal multimédia selon au moins l'une des revendications précédentes, **caractérisé en ce que** le système binoculaire (7) présente pour chaque oculaire une lentille convexe à longue distance focale.

12. Terminal multimédia selon la revendication 11, **caractérisé en ce qu'**au moins un côté des lentilles convexes est asphérique.

13. Terminal multimédia selon au moins l'une des revendications précédentes, **caractérisé en ce que** le système binoculaire (7) est configuré comme loupe serre-tête.

14. Terminal multimédia selon au moins l'une des revendications précédentes, **caractérisé en ce que** le moyen de pose à l'extérieur est configuré comme colonne (4) ou comme statif.

15. Terminal multimédia selon au moins l'une des revendications précédentes, **caractérisé en ce que**
a) le terminal multimédia présente un moyen de visée (3) d'un objet réel (50a, 50b, 50c), en particulier des bâtiments d'un paysage urbain, et **en ce que** le moyen de visée (3) est disposé à déplacement sur un dispositif fixe de montage (4) de telle sorte que le moyen de visée (3) puisse être orienté dans l'espace sur un objet réel (50a, 50b, 50c) et
b) **en ce qu'**il présente un moyen de détection de position qui détecte l'orientation spatiale (40) du moyen de visée (3),
c) le moyen de calcul (1) permettant d'afficher, en particulier de manière automatique, au moins une image (32) conservée en mémoire en corrélation avec l'orientation spatiale (40) du moyen de visée (3) sur le moyen d'affichage (2).

16. Terminal multimédia selon la revendication 15, **caractérisé en ce que** la corrélation entre l'orientation (40) et au moins une image (32) conservée en mémoire est conservée sous la forme d'un tableau et/ou d'une relation fonctionnelle dans le moyen de calcul (1).

17. Terminal multimédia selon la revendication 15 ou 16, **caractérisé en ce que** le moyen de visée (3) est disposé sur le dispositif de montage (4) de manière à pouvoir tourner autour d'au moins un axe et/ou à coulisser le long d'un axe.

18. Terminal multimédia selon au moins l'une des revendications 15 à 17, **caractérisé en ce que** le moyen de détection de position détecte l'orientation (40) du moyen de visée (3) par l'intermédiaire d'au moins une sonde d'angle de rotation.

19. Terminal multimédia selon au moins l'une des revendications 15 à 18, **caractérisé en ce que** le moyen de visée (3) présente un système optique (5) qui enregistre au moins un objet réel (50a, 50b, 50c).

20. Terminal multimédia selon la revendication 19, **caractérisé en ce que** le système optique (5) présente au moins une caméra CCD dont l'image peut être représentée sur le moyen d'affichage (2).

21. Terminal multimédia selon au moins l'une des revendications précédentes, **caractérisé par** un moyen de commutation qui permet de commuter manuellement entre une vue réelle (50a, 50b, 50c) et au moins une image (32) conservée en mémoire.

22. Terminal multimédia selon au moins l'une des revendications précédentes, **caractérisé par** un moyen de sélection qui permet de sélectionner des images (32) conservées en mémoire et corrélées à la vue réelle (50a, 50b, 50c).

23. Terminal multimédia selon au moins l'une des revendications précédentes, **caractérisé en ce qu'**au moins une image (32) conservée en mémoire est une image fixe et/ou une succession d'images, en particulier un film vidéo.

24. Terminal multimédia selon au moins l'une des revendications précédentes, **caractérisé en ce qu'**au moins une image (32) conservée en mémoire est une représentation de la même vue réelle (50a, 50b, 50c) dans le passé et/ou une vue virtuelle de la vue réelle (50a, 50b, 50c).

25. Terminal multimédia selon au moins l'une des revendications précédentes, **caractérisé par** un moyen qui permet d'agrandir ou diminuer la vue réelle (50a, 50b, 50c) et/ou au moins une image (32) conservée en mémoire.

26. Terminal multimédia selon au moins l'une des revendications précédentes, **caractérisé en ce que** l'alimentation en courant s'effectue par un câble de courant, des batteries et/ou une installation photovoltaïque.
